# EUROPÄISCHE PATENTSCHRIFT

(11) **EP 0 704 064 B1**
(45) Veröffentlichungstag und Bekanntmachung des Hinweises auf die Patenterteilung: **25.02.1998**
(21) Anmeldenummer: 94918284.4
(22) Anmeldetag: 20.06.1994
(51) Int. Cl.: G01V 3/10, H03K 17/95

(54) **MAGNETISCHE BLENDE**
MAGNETIC SCREEN
ECRAN MAGNETIQUE

(30) Priorität: 18.06.1993 DE 4320250
(43) Veröffentlichungstag der Anmeldung: 03.04.1996
(73) Patentinhaber: SIEMENS MATSUSHITA COMPONENTS GmbH & CO KG, 81617 München (DE)
(72) Erfinder: ESGUERRA, Mauricio,Dipl.-Phys., D-82008 Unterhaching (DE)
(74) Vertreter: Löpertz, Friedrich
(86) Internationale Anmeldenummer: DE9400700
(87) Internationale Veröffentlichungsnummer: WO9500864

(56) Entgegenhaltungen:
- WO-A-86/07637
- DE-A- 3 505 765
- DE-A- 3 619 238

## Beschreibung

Die vorliegende Erfindung betrifft eine magnetische Blende nach dem Oberbegriff des Patentanspruchs 1.

Magnetische Blenden der gattungsgemäßen Art sind beispielsweise in der DE-PS 35 05 765 beschrieben. In dieser Druckschrift wird eine magnetische Blende der in Rede stehenden Art als Prüfeinrichtung zur Funktionskontrolle eines induktiven Näherungsschalters bezeichnet. Diese Prüfeinrichtung weist eine vom Sensorfeld einer Schwingkreisspule des induktiven Näherungsschalters durchflutete Sekundarspule auf, wodurch mit der Prüfeinrichtung der Schwingkreis des induktiven Näherungsschalters aus seinem Ist-Zustand in den hinsichtlich der Dämpfung jeweils entgegengesetzten Zustand umsteuerbar ist. Dabei hält die Sekundärspule bei offenen Spulenanschlüssen den Schwingkreis in unbedämpftem Zustand und bei Anschließen eines Prüfwiderstandes an die Spulenanschlüsse in bedämpften Zustand. Die Sekundarspule sitzt auf einem eigenen Sekundärkern, der bei offenen Spulenanschlüssen und bei über den Prüfwiderstand geschlossener Sekundarspule das Sensorfeld der Schwingkreisspule vollständig gegen einen Metallauslöser für den induktiven Näherungsschalter abschirmt und nur bei kurzgeschlossener Sekundarspule ein sekundäres Sensorfeld für den Metallauslöser aufbaut. Eine derartige Prüfeinrichtung kann deshalb als magnetische Blende bezeichnet werden, weil durch unterschiedlich große Ströme in der Sekundarspule das in den Außenraum wirkende Sensorfeld ein- und ausgeschaltet bzw. ein- und ausgeblendet wird.

Eine derartige magnetische Blende ist insofern nachteilig, als zwei Spulen, nämlich die Schwingkreisspule des induktiven Näherungsschalters und die Sekundarspule der Prüfeinrichtung erforderlich sind, welche zusammen einen Transformator bilden. Daher wird der Aufbau des magnetischen Kreises der magnetischen Blende relativ sperrig.

Der vorliegenden Erfindung liegt die Aufgabe zugrunde, eine magnetische Blende der in Rede stehenden Art anzugeben, welche im Aufbau relativ kompakt ist.

Diese Aufgabe wird bei einer magnetischen Blende der eingangs genannten Art erfindungsgemäß durch die Merkmale des kennzeichnenden Teils des Patentanspruchs 1 gelöst.

Die erfindungsgemäße Blende ist kompakt aufgebaut, weil sie nur eine einzige Spule besitzt und das Ein- und Ausblenden des in den Außenraum wirkenden Magnetfeldes durch einen zweiteiligen, aber körperlich kompakten Magnetkreis mit verschiedenen Materialien unterschiedlicher reversibler Permeabilität realisiert wird.

Weiterbildungen der Erfindung sind Gegenstand von abhängigen Patentansprüchen.

Die Erfindung wird nachfolgend anhand eines Ausführungsbeispiels gemäß den Figuren der Zeichnung näher erläutert. Es zeigt:
- Figur 1: schematisch den Aufbau einer erfindungsgemäßen magnetischen Blende;
- Figur 2: ein schematisches Ersatzschaltbild einer Schaltung zum Betrieb einer magnetischen Blende nach Figur 1; und
- Figur 3: ein Diagramm des Verlaufs der reversiblen Permeabilität in Abhängigkeit von der magnetischen Induktion für zwei verschiedene magnetische Materialien in einer magnetischen Blende nach Figur 1.

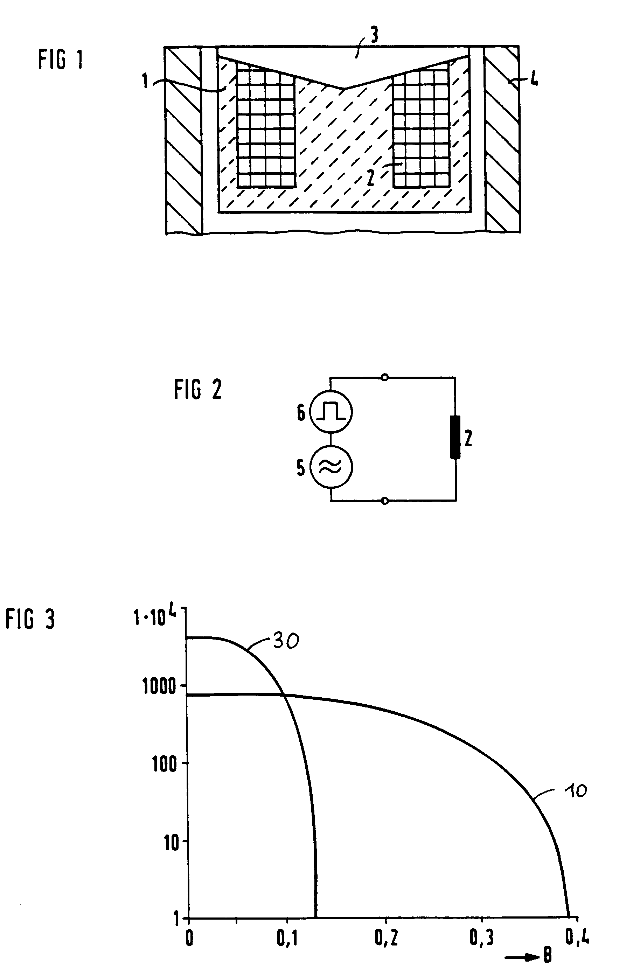

Bei der Ausführungsform einer magnetischen Blende nach Figur 1 ist ein Halbschalenkern 1 vorgesehen, welcher eine Spulenwicklung 2 trägt. Auf einer Außenseite der durch den Halbschalenkern 1 und die Wicklung 2 gebildeten Spule ist ein magnetisierbares Element 3 aufgesetzt. Die durch den Halbschalenkern 1 und die Wicklung 2 gebildete elektrische Spule sowie das magnetische Element 3 sind bündig in ein metallisches Gehäuse 4 eingebaut.

Ein wesentliches Merkmal der erfindungsgemäßen magnetischen Blende besteht darin, daß das magnetisierbare Element 3 durch ein ferromagnetisches Material gebildet ist, das bei einer magnetischen Induktion in Sättigung gelangt, die gegenüber der für das Material des Kerns 2 der Spule 1, 2 zu dessen Sättigung notwendigen Induktion klein ist. Im Diagramm nach Figur 3 ist dieser Sachverhalt für die Abhängigkeit der reversiblen Permeabilität µrel in Abhängigkeit von der magnetischen Induktion B für die Materialien des Spulenkerns 1 bzw. des magnetisierbaren Elementes 3 nach Figur 1 dargestellt. Gemäß einer Kurve 30 gelangt das Material für das magnetisierbare Element 3 bereits bei relativ kleinen Induktionen B in die Sättigung, d. h. die reversible Permeabilität µre1 fällt bei diesen relativ kleinen Induktionen bereits auf 1 ab. Demgegenüber fällt gemäß einer Kurve 10 für das Material des Spulenkerns 1 die relative Permeabilität µre1 erst bei relativ großen Induktionen auf 1 ab.

Gemäß einem weiteren Merkmal der Erfindung wird dem die Wicklung 2 der Spule 1, 2 durchfließenden Strom, welcher das Magnetfeld der magnetischen Blende im Außenraum erzeugt, intermittierend ein impulsförmiger Strom überlagert, welcher ausreicht, um das magnetisierbare Element 3 in die Sättigung zu steuern. Ist dies der Fall, so kann das gesättigte magnetisierbare Element 3 den magnetischen Kreis der Spule 1, 2 nicht mehr schließen, so daß das von ihr erzeugte Feld in den Außenraum reicht, das heißt die magnetische Blende ist offen. Der Spulenkern 1 und die Wicklung 2 arbeiten in üblicher Weise zur Erzeugung des in den Außenraum reichenden Magnetfeldes, weil das Material des Spulenkerns 1 gemäß dem Diagramm nach Figur 3 im Vergleich zum Material des magnetisierbaren Elements 3 erst bei relativ hohen Induktionen in Sättigung gelangt. In den Pausen des intermittierenden impulsförmigen Stroms wird dagegen das magnetisierbare Element 3 nicht gesättigt, so daß es den magnetischen Kreis der Spule 1, 2 schließt und damit die magnetische Blende geschlossen wird, das heißt es wirkt kein magnetisches Feld im Außenraum.

Figur 2 zeigt ein schematisches Schaltbild zur elektrischen Ansteuerung der Wicklung 2 der Spule 1, 2 mit einer das stationäre magnetische Feld erzeugenden Wechselquelle 5 und einer Impulsquelle 6, durch deren Strom in der Wicklung 2 die magnetische Blende intermittierend geöffnet und geschlossen wird.

Um bei dem in Figur 1 dargestellten Aufbau der magnetischen Blende konstante Querschnittsflächenverhaltnisse für den Magnetfluß zu schaffen, ist in Weiterbildung der Erfindung das magnetisierbare Element auf seiner der offenen Seite der Halbschalenkernspule 1 zugekehrten Seite derart kegelförmig ausgebildet, daß die Kegelspitze in Spulenmitte liegt, wobei die Halbschalenkernspule 1 an ihrer offenen Seite an die Kegelform des magnetisierbaren Elementes 3 angepaßt ist.

Eine magnetische Blende der vorstehend erläuterten Art ist vorzugsweise in einem induktiven Näherungsschalter verwendbar.

## Patentansprüche

1. Magnetische Blende mit einer elektrischen Spule (1, 2) und einem mit dieser induktiv gekoppelten magnetisierbaren Element (3), die zusammen ein magnetisches Feld in den Außenraum abstrahlen, wobei das magnetische Feld im Außenraum durch elektrische Umschaltung vom ungesättigten in den gesättigten Zustand des magnetisierbaren Elementes (3) ein- und ausschaltbar ist,
**dadurch gekennzeichnet**, daß das magnetisierbare Element (3) durch ein ferromagnetisches Material gebildet ist, das bei einer magnetischen Induktion in Sättigung gelangt, die gegenüber der für die Sättigung des Materials des Kerns (1) der Spule (1, 2) notwendigen Induktion klein ist, und daß an die Spule (1, 2) eine Impulsspannungsquelle (6) angekoppelt ist, aus der einem das magnetische Feld erzeugenden Strom ein impulsförmiger Strom überlagerbar ist, der zur Erzeugung einer magnetischen Induktion ausreicht, bei der das magnetisierbare Element (3) in Sättigung gelangt.

2. Magnetische Blende nach Anspruch 1, **dadurch gekennzeichnet**, daß die Spule (1, 2) als Halbschalenkernspule ausgebildet ist und daß das magnetisierbare Element (3) ein auf die offene Seite der Spule (1, 2) aufgesetztes und diese verschließendes Element ist.

3. Magnetische Blende nach Anspruch 2,
**dadurch gekennzeichnet**, daß das magnetisierbare Element (3) auf seiner der offenen Seite der Halbschalenkernspule (1) zugekehrten Seite derart kegelförmig ausgebildet ist, daß die Kegelspitze in Spulenmitte liegt, und daß die Halbschalenkernspule (1) an ihrer offenen Seite an die Kegelform des magnetisierbaren Elementes angepaßt ist.

4. Magnetische Blende nach einem der Ansprüche 1 bis 3, **gekennzeichnet durch** einen bündigen Einbau in ein elektrisch leitendes metallisches Trägergehäuse (4).

5. Verwendung einer magnetischen Blende nach einem der Ansprüche 1 bis 4 in einem induktiven Näherungsschalter.

## Claims

1. Magnetic screen having an electrical coil (1, 2) and a magnetizable element (3) inductively coupled thereto, which together radiate a magnetic field into the external space, it being possible to switch the magnetic field in the external space on and off by electrically switching over from the unsaturated to the saturated state of the magnetizable element (3), characterized in that the magnetizable element (3) is formed by a ferromagnetic material which reaches saturation at a magnetic induction which is small in relation to the induction necessary to saturate the material of the core (1) of the coil (1, 2), and in that there is coupled to the coil (1, 2) a pulse voltage source (6) from which it is possible to superimpose on a current which generates the magnetic field a pulsed current which is sufficient to generate a magnetic induction at which the magnetizable element (3) reaches saturation.

2. Magnetic screen according to Claim 1, characterized in that the coil (1, 2) is designed as a half-shell-type core coil, and in that the magnetizable element (3) is an element which is placed onto the open side of the coil (1, 2) and closes off the latter.

3. Magnetic screen according to Claim 2, characterized in that the magnetizable element (3) is of conical construction on its side facing the open side of the half-shell-type core coil (1), in such a way that the vertex of the cone lies in the centre of the coil, and in that the half-shell-type core coil (1) is matched at its open side to the conical shape of the magnetizable element.

4. Magnetic screen according to one of Claims 1 to 3, characterized by flush fitting into an electrically conductive, metallic carrier housing (4).

5. Use of a magnetic screen according to one of Claims 1 to 4 in an inductive proximity switch.

## Revendications

1. Ecran magnétique comportant une bobine électrique (1, 2) et un élément magnétisable (3) couplé à celle-ci de façon inductive, qui dégagent ensemble un champ magnétique dans l'espace extérieur, le champ magnétique pouvant être mis en circuit ou hors circuit dans l'espace extérieur par commutation électrique de l'état non saturé à l'état saturé de l'élément magnétisable (3), caractérisé en ce que l'élément magnétisable (3) est formé par une matière ferromagnétique, qui parvient à saturation lors d'une induction magnétique, qui est petite par rapport à l'induction nécessaire pour la saturation de la matière du noyau (1) de la bobine (1, 2), et en ce qu'une source de tension impulsionnelle (6) est couplée à la bobine (1, 2), à partir de laquelle un courant par impulsions peut être superposé à un courant produisant le champ magnétique, ledit courant par impulsions suffisant pour produire une induction magnétique, dans laquelle l'élément magnétisable (3) arrive à saturation.

2. Ecran magnétique selon la revendication 1, caractérisé en ce que la bobine (1, 2) est conçue en tant que bobine à noyau semi-monocoque et en ce que l'élément magnétisable (3) est un élément posé sur le côté ouvert de la bobine (1, 2) et fermant celle-ci.

3. Ecran magnétique selon la revendication 2, caractérisé en ce que l'élément magnétisable (3) est conçu de façon conique sur son côté adjacent au côté ouvert de la bobine à noyau semi-monocoque (1) de telle sorte que la pointe se trouve au milieu de la bobine, et que la bobine à noyau semi-monocoque (1) est adaptée sur son côté ouvert à la conicité de l'élément magnétisable.

4. Ecran magnétique selon l'une des revendications 1 à 3, caractérisé par un montage à fleur se trouvant dans un boîtier porteur métallique électriquement conducteur (4).

5. Utilisation d'un écran magnétique selon l'une des revendications 1 à 4 dans un détecteur de proximité inductif.
